# EUROPEAN PATENT APPLICATION

(11) **EP 1 462 812 A1**
(43) Date of publication of application: **29.09.2004**
(21) Application number: 02804663.9
(22) Date of filing: 20.03.2002
(51) Int. Cl.: G01R 21/00, G01R 22/00, H04J 13/02, H04B 1/69, G08C 17/02

(54) **METHOD AND DEVICE FOR CONTROLLING ENERGY CONSUMPTION BY A GREAT NUMBER OF CONSUMERS**

(30) Priority: 10.12.2001 RU 2001134007
(71) Applicant: Surnov, Sergei Ivanovich, Moskovskaya obl., 141070 (RU)
(72) Inventor: Surnov, Sergei Ivanovich, Moskovskaya obl., 141070 (RU)
(74) Representative: HOFFMANN - EITLE
(86) International application number: PCT/RU2002/000105
(87) International publication number: WO 2003/050549

(57) **Abstract**

The method for controlling the consumption of energy resources by a plurality of consumers according to the present invention is carried out with the aid of a device, in which each consumer of power resources is provided with at least one meter (15) which converts data on the consumption of energy resources into corresponding electric signals. Said electric signals are grouped with the aid of a controller (14) to form a data array, followed by converting the grouped electric signals into a form suitable for transmission via a radio link (9) in the DECT standard. The converted electric signals are transmitted via the radio link (9) in the DECT standard, received and converted for processing by an electronic computer unit (1), the latter being used for automatically processing the received electric signals.

## Description

### Technical Field

The present invention relates to the field of energy saving and more particularly to a method of and a device for controlling the consumption of energy resources by a plurality of consumers.

### State of the Art

In municipal economy and industry diverse methods are widely used for controlling and accounting the consumption of electric energy resources by a plurality of consumers with a view to optimizing the consumption and verifying the made payments. The known methods in the majority of cases are based on the use of corresponding sensors or meters, the energy consumption data being periodically read out directly from the meters by employees of the electric power distributing company either visually or manually with the aid of various electronic and mechanical appliances. These methods are characterized by appreciable costs involved by labor expenditures required for reading the indications from a great number of meters located, more often than not, at great distances from one another. Owing to this fact, readings are usually taken rather seldom (1-2 times a year) and, as a result, control of the consumption of energy resources cannot be performed effectively.

Known in the art is a system for automated control and accounting of the consumption of energy resources (see the journal "Modern Automation Technologies", No. 3, 2000, A. Rasputin and I. Fedotov "Software-and-Hardware Complex EKOM: Accounting and Managing of Electric Power Resources"), built around pulse adders, for electric power accounting systems (USPD) with a serial interface RS-232/RS-485. The method for controlling and accounting the consumption of electric energy resources, based on this system, makes it possible to process, with the aid of a controller, data from a limited number of energy consumption meters located not far from one another, followed by displaying and listing the processed information. Because of technical restrictions inherent in the system on the distance between the meters and the controller, as well as on the number and type of the meters, only a local energy consumption control unit can be organized on the basis of this system.

Also known (from the same publication) is an automated system and a method associated therewith for controlling the consumption of diverse energy resources by a plurality of consumers, based on the software-and-hardware complex EKOM-3000. This system makes it possible to carry out automated control and accounting of the consumption of various energy resources by an appreciable number of consumers, with data transmission to a central automated processing station located up to 1200 meters away. This system can unite a plurality of meters with an interface RS-232/RS-485 as local subsystems.

In the method associated with the given system for controlling the consumption of energy resources, a plurality of consumers of diverse power resources are provided with meters which convert energy consumption data into electric signals. The electric signals from the corresponding meters are grouped territorially with the aid of controllers and transmitted via electrical communication lines to a central station which comprises an electronic computer unit based on the software-and-hardware complex EKOM-3000, where automated processing and accounting of said signals are performed.

An insufficiently large radius of action, the necessity to use wires for commutating groups of meters with the central station involve appreciable material and organization costs and limit the variants of using the method and system concerned. Such method and system for controlling and accounting energy resources can be put to effective use at relatively small industrial enterprises and in individual residential complexes. At the same time, they are of little use at large-scale enterprises and within the scope of municipal economy, where long distances have to be covered, while running new service lines is difficult. The use of conventional systems for these purposes will call for creating a great number of central stations and laying a considerable number of additional wires and distribution lines, which will involve very heavy expenses. These systems will likewise be inconvenient in service.

Known in the art is a technical solution (see the journal "Technologies and Communication Facilities", No. 4, 2001, M.V. Pavlishin and A.N. Ivanov, "PLC Technology for Solving the "Last Mile" Problem", pp. 52-57), providing transmission of information signals from a plurality of meters to far-away processing stations via electric power mains. This technical solution can be used for organizing a data transmission system from energy consumption meters to the central station which comprises an electronic computer unit. An advantage of this solution is the use of standard electric wiring provided in every dwelling house and industrial enterprise. In practical application of the given solution for a large number of energy meters, there arise considerable technical difficulties because of noise and distortion of information, a factor that does not allow one to create an efficient control system based on this solution. Besides, the system concerned calls for modernizing all the meters with resorting to additional equipment, this involving appreciable material inputs.

### Disclosure of the Invention

The principal object of the present invention is to provide a method for controlling and accounting the consumption of diverse types of energy resources by a plurality of consumers, useful for servicing a large number of consumers which may be located at considerable distances from a central station which comprises an electronic computer unit, and from one another, which method would not require a large number of additional service lines to be laid; as well as to provide a device for carrying said method into effect.

The set object is accomplished also by that a device for controlling and accounting the consumption of energy resources by a plurality of consumers, comprising a plurality of consumption meters at least equal to the plurality of consumers, said consumption meters converting data on the consumption of energy resources into corresponding electric signals, at least one controller connected to the outputs of the meters, for grouping the electric signals to form a data array, and at least one electronic computer unit for automated processing of the electric signals and accounting thereof, connected to the controller, according to the invention, further comprises at least two receiver-transmitter units made with the possibility of converting the electric signals into the DECT standard and receiver-transmitter the signal via a radio link in the DECT standard, one of which units is installed near the controller and is connected thereto, and the other of said units is installed near the electronic computer unit and is connected thereto.

Preferably an electronic computer unit and the second receiver-transmitter unit are interconnected by a switching unit, in the capacity of which an automatic telephone exchange is employed.

### Brief Description of the Drawings

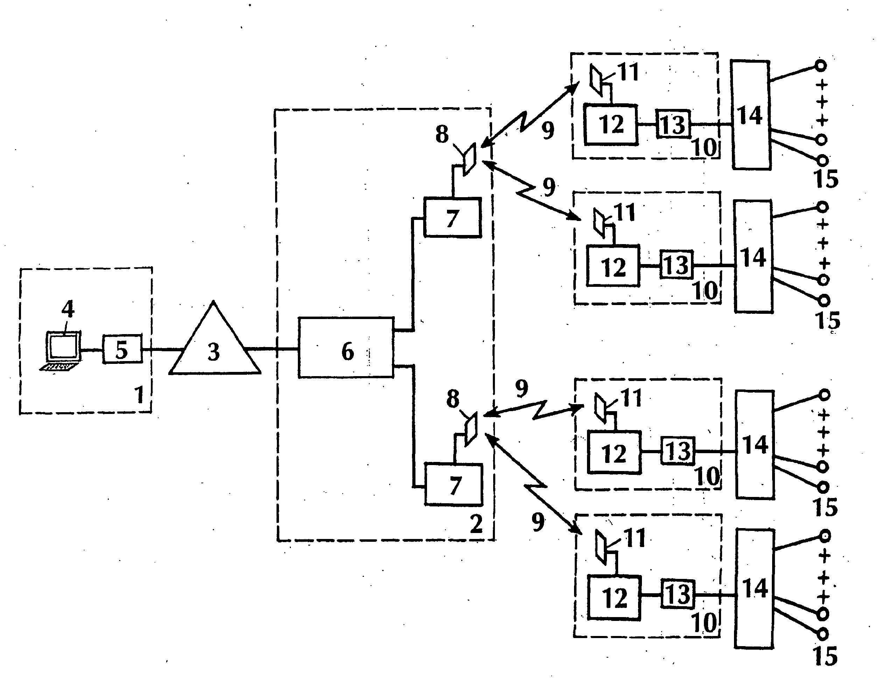

The invention will further be explained by a description of a non-limiting particular embodiment thereof with references to the accompanying drawing which shows diagrammatically one of variants of embodying the device of the invention for controlling and accounting the consumption of energy resources by a plurality of consumers.

### Best Mode of Carrying out the Invention

The device for controlling power resources according to the particular embodiment of the present invention comprises an electronic computer unit 1, connected by electric wires with a receiver-transmitter unit 2 via a switching unit 3. The electronic computer unit 1 comprises an electrically connected computer 4 and a first interface device 5. Instead of the computer 4, use may be made, for example, of several computers or a computer network with appropriate software, or of a specialized software-and-hardware complex (for example, EKOM-3000). As the switching unit 3 use can be made of an electric interchanger, preferably an automatic telephone exchange. The interface device 5 is capable of providing interface matching when transmitting data from/to the computer 4 owing to realizing one of the following protocols: RS232 (V.24), USB, V.35, Ethernet or a similar protocol. The receiver-transmitter unit 2 comprises electrically interconnected: an operating controller 6, two base radio units 7 coupled parallel thereto, each having an antenna 8. The number of the base radio units 7 and the antennas 8, accordingly, may vary, depending on the characteristics of the terrain where radio communications are organized, remoteness of the energy consumers from the electronic computer unit 1, and other conditions. The connection of the electronic computer unit 1 and the receiver-transmitter unit 2 is accomplished with a possibility of directing information requests from the unit 1 to the unit 2 and exchanging information therebetween. The receiver-transmitter unit 2 is adapted to provide communication and information exchange by a radio link 9 with at lest one (in the present example with four) receiver-transmitter units 10, each of them comprising an antenna 11, a terminal subscriber's radio unit 12 and an interface device 13, all electrically coupled.

Each receiver-transmitter unit 10 is electrically connected to at least one (in the example under consideration also to one) controller 14. The interface device 13 provides matching the interfaces during data transmission between the receiver-transmitter unit 10 and the controller 14. The controller 14 comprises, for example, a microcomputer with corresponding software, provided with discrete and/or analog signals input/output modules. Each controller 14 is electrically connected to corresponding outputs of a plurality of meters 15 which convert the measured data on energy consumption by consumers into corresponding analog or discrete electric signals. Said controllers 14 are made capable to receive electric signals from the meters 15 and accumulate them, convert them into a data array, store and transmit them in accordance with a prescribed program. The meters 15 may differ in design, being adapted to measure one or various types of power resources.

In the particular embodiment of the invention under consideration four first receiver-transmitter units 10 and four controllers 14 are employed. The number of these devices may be varied, depending on the required configuration of the device for controlling and accounting power resources. The configuration of the device of the invention is selected with taking into account the number of consumers, location thereof, the distance between the consumers and the electronic computer unit 1, topography, and other conditions.

An essential feature of the present invention is that said receiver-transmitter units 2 and 10, and the operating controller 6 are made to be capable of functioning in accordance with the European Telecommunications Standard ETS 300 175, known as the Digital Enhanced Cordless Telecommunications (DECT).

In the given particular embodiment of the invention each of the controllers 14 is electrically connected by wires to a corresponding plurality of meters 15, disposed at a small distance from one another, as a rule, on one object (for example, in a house or a production shop). The antennas 11 of the receiver-transmitter unit 10 are usually installed at the highest point, say, on the roof of the object. Each of the antennas 11 is directed to the respective antenna 8 of the receiver-transmitter radio unit 2 to provide efficient operation of the radio link 9. The receiver-transmitter unit 2 and the electronic computer unit 1 are mounted in a building located at a distance to provide stable radio signal transmission from the receiver-transmitter unit 10. With the use of directional antennas in the device of the present invention,, said distance can be 16 km and more. The antennas 8 of the receiver-transmitter unit 2 are installed on the roof of the building. The choice of the type of antenna and the installation are carried out with due regard for the topography, peculiarities of the development of the territory to be serviced, and the distance between the device components, in accordance with the procedure known to a person skilled in the art.

The use of the device of the present invention allows one to service extensive territories using a single electronic computer unit 1, as shown in the given particular variant. At the same time, the invention also encompasses a configuration of the device with several electronic computer units 1, which sometimes is convenient, e.g., for organization reasons.

The method for controlling and accounting the consumption of energy resources by a plurality of consumers will become clear from a description of operation of the device of the present invention, given hereinbelow.

The data on the consumption of energy resources, obtained with the help of the meters 15 are converted into corresponding electric signals. These electric signals are grouped to form a data array and stored in accordance with a program and a protocol in the memory units of the controllers 14. In accordance with the program, using the computer 4 of the electronic computer unit 1, requests to the selected controller are formed in specified order, e.g., alternately, to transmit the accumulated information. The requests are conveyed via the interface device 5 to the switching unit 3, say, an automatic telephone exchange. Said switching unit 3 is used for providing automatic commutation of the computer 4 with the selected controller 14 through corresponding sections of the electric mains and the radio link 9. In accordance with the automatic commutation performed by the controller 3, the request is transmitted to a definite base radio unit 7 via the operating controller 6, which is used for converting the request intc the form corresponding to the DECT standard. In conformity with the DECT standard, the requests are transmitted with the aid of the antenna 8 of said base radio unit 7 of the receiver-transmitter unit 2, via the radio link 9 to the antenna 11 of the respective receiver-transmitter unit 10, with the help of which the requests are received and transmitted via the interface device 13 to the selected controller 14. In response to the received request, the electric signals received from the meters 15 and stored in the memory unit of the controller 14 are transmitted. In accordance with the DECT standard, said transmission is carried out via the antenna 11 of the receiver-transmitter unit 10 connected to the controller 14 via the radio link 9 to the respective antenna 8 of the bare radio unit 7 of the receiver-transmitter unit 2, with the aid of which the signals are received and transmitted via the controller 6 to the electronic computer unit 1. In the electronic computer unit 1 the received signals are subjected to automated processing with the help of the computer 4 and are thus converted into information having a form convenient for controlling and accountirg the consumption of energy resources by a plurality of consumers. An essential feature of the operation of the device of the present invention is that the receiver-transmitter units 2 and 10, the controller 6 and the radio link 9 are organized and function in accordance with the DECT standard.

The device of the present invention is highly efficient in servicing vast territories with high traffic density (up to 10 thousand erg per km²), i.e., it can service a great number of controllers 14 (up to 100 thousand controllers per km ). An advantage of the device is also the fact that its work requires no frequency planning, because it uses unlicensed frequencies. The technology of continuous dynamic selection of channels used in the device and provided for in the DECT standard contributes to a highly efficient application of the whole accessible frequency band, diverse applications included. The efficient signal transmission is provided irrespective of topography owing to the transmitter-receiver unit antennas properly located on the existing heights (buildings, towers, natural elevations, etc.) and/or due to the use of retransmitters. The application of directional antennas in the device of the present invention provides a device range up to 16 km and more, which is enough to cover the territory of a big town.

### Industrial Applicability

The method and device of the present invention can be used for organizing control of the consumption of power resources of various types by plurality of consumers in municipal economies and at industrial enterprises. The present invention makes it possible to raise substantially the efficiency of control, since it provides control of energy consumption by every particular user with a view to improving the convenience in verifying the carried out payments. The energy resources can be electric power, water, natural gas, heat, liquid fuel, compressed air, oxygen, etc.

## Claims

1. A method for controlling the consumption of energy resources by a plurality of consumers, in which each consumer from the plurality is equipped with at least one meter (15) which converts data on the consumption of energy resources into corresponding electric signals, the electric signals are grouped with the aid of a controller (14) to form a data array, and the grouped electric signals are transmitted to an electronic computer unit (1), wherein their automated processing and accounting are carried out, **characterized in that** the grouped electric signals are converted into a form suitable for transmission via a radio link (9) in compliance with the DECT standard, the converted electric signals are transmitted by the radio link (9) in the DECT standard, the electronic computing device (1) receives the electric signals and converts same into a processable form.

2. The method for controlling according to claim 1, **characterized in that** signal transmission via the radio link (9) is controlled with the aid of an automatic telephone exchange connected to with the electronic computer unit.

3. A device for controlling the consumption of energy resources by a plurality of consumers, comprising a plurality of consumption meters (15) at least equal to the plurality of consumers, said consumption meters converting data on the consumption of energy resources into corresponding electric signals, at least one controller (14) connected to the outputs of the meters (15), for grouping the electric signals to form a data array, and at least one electronic computer unit (1) for automated processing of the electric signals and accounting thereof, connected to the controller (3), **characterized in that** the device further comprises at least two receiver-transmitter units (2, 10) made with the possibility of converting the electric signals into the DECT standard and receiver-transmitter the signal via a radio link (9) in the DECT standard, one of which units is installed near the controller (14) and is electrically connected thereto, and the other of said units is installed near the electronic computer unit (1) and is electrically connected thereto.

4. The device of claim 3, **characterized in that** the electronic computer unit and the receiver-transmitter unit are interconnected via a switching unit in the capacity of which an automatic telephone exchange is used.
